# EUROPEAN PATENT APPLICATION

(11) **EP 4 521 635 A1**
(43) Date of publication of application: **12.03.2025**
(21) Application number: 24186409.9
(22) Date of filing: 04.07.2024
(51) Int. Cl.: H03D 7/14

(54) **RADIO-FREQUENCY MIXER WITH SHARED BIAS CURRENT**

(30) Priority: 28.07.2023 US 202318361302
(71) Applicant: Apple Inc., Cupertino, CA 95014 (US)
(72) Inventor: CHAKRABARTI, Anandaroop, Cupertino, CA 95014 (US)
(74) Representative: Lang, Johannes

(57) **Abstract**

An electronic device may include wireless circuitry with a mixer. The mixer may include a transconductor with first and second input transistors, a switching quad with first and second pairs of mixer transistors, and a transformer coupled between the transconductor and the switching quad. The transformer may have a primary winding and a secondary winding. The transformer may have a conductive path that couples a center tap contact of the primary winding to a center tap contact of the secondary winding. The conductive path may configure the transformer to share a DC bias current between the transconductor and the switching quad. This may eliminate the need to bias the transconductor and the switching quad using different power supply voltages, thereby minimizing power consumption without sacrificing performance.

## Description

This application claims priority to U.S. patent application No. 18/361,302, filed July 28, 2023, which is hereby incorporated by reference herein in its entirety.

### Field

This disclosure relates generally to electronic devices, including electronic devices with wireless communications circuitry.

### Background

Electronic devices can be provided with wireless communications capabilities. An electronic device with wireless communications capabilities has wireless communications circuitry with one or more antennas. The wireless communications circuitry uses the antennas to receive and transmit radio-frequency signals.

The wireless communications circuitry can include a transceiver having one or more mixers. A mixer can be used to modulate signals from a first frequency to a second frequency. It can be challenging to design mixers that exhibit sufficient levels of performance while also minimizing power consumption of the wireless communications circuitry.

### Summary

An electronic device may include wireless circuitry. The wireless circuitry may include one or more mixers that receive an oscillating signal. The mixer can be a radio-frequency transmitting mixer or a radio-frequency receiving mixer. A local oscillator can generate the oscillating signal. The mixer can be a transformer based mixer exhibiting improved linearity.

The mixer may include a transconductor that includes first and second input transistors, a switching quad that includes first and second pairs of mixer transistors, and a transformer coupled between the transconductor and the switching quad. The transformer may have a primary winding and a secondary winding. The transformer may have a conductive path that couples a center tap contact of the primary winding to a center tap contact of the secondary winding. The conductive path may configure the transformer to share a DC bias current between the transconductor and the switching quad. This may eliminate the need to bias the transconductor and the switching quad using different power supply voltages, thereby minimizing power consumption without sacrificing performance.

An aspect of the disclosure provides mixer circuitry. The mixer circuitry can include a transformer having a first winding and a second winding. The mixer circuitry can include a first input transistor coupled to a first terminal of the first winding and configured to receive an input signal. The mixer circuitry can include a second input transistor coupled to a second terminal of the first winding and configured to receive the input signal. The mixer circuitry can include a first pair of mixer transistors coupled to a first terminal of the second winding and configured to receive an oscillating signal. The mixer circuitry can include a second pair of mixer transistors coupled to a second terminal of the second winding and configured to receive the oscillating signal. The mixer circuitry can include a conductive path that couples a center tap contact of the first winding to a center tap contact of the second winding.

An aspect of the disclosure provides mixer circuitry. The mixer circuitry can include a transconductor. The mixer circuitry can include mixer transistors. The mixer circuitry can include a transformer that couples an output of the transconductor to an input of the mixer transistors. The transformer can include a first coil having a first center tap contact. The transformer can include a second coil magnetically coupled to the first coil, the second coil having a second center tap contact that is coupled to the first center tap contact over a conductive path.

An aspect of the disclosure provides an electronic device. The electronic device can include an antenna. The electronic device can include a transceiver configured to convey radio-frequency signals using the antenna. The transceiver can include a first pair of transistors having first gate terminals configured to receive an input signal and having first source-drain terminals. The transceiver can include a second pair of transistors having second gate terminals configured to receive a local oscillator (LO) signal and having second source-drain terminals. The transceiver can include a third pair of transistors having third gate terminals configured to receive the LO signal and having third source-drain terminals. The transceiver can include a transformer having a first inductor and a second inductor, wherein the first inductor is coupled between the first source-drain terminals, the second inductor is coupled between the second source-drain terminals and the third source-drain terminals, and a center tap of the first inductor is coupled to a center tap of the second conductor over a conductive path.

### Brief Description of the Drawings

FIG. 1 is a diagram of an illustrative electronic device having wireless circuitry in accordance with some embodiments.
FIG. 2 is a diagram of illustrative wireless circuitry having a transceiver with mixer circuitry in accordance with some embodiments.
FIG. 3 is a block diagram of illustrative mixer circuitry in accordance with some embodiments.
FIG. 4 is a circuit diagram of illustrative mixer circuitry having a transconductor, a switching quad, and a transformer that shares bias current between the transconductor and the switching quad in accordance with some embodiments.

### Detailed Description

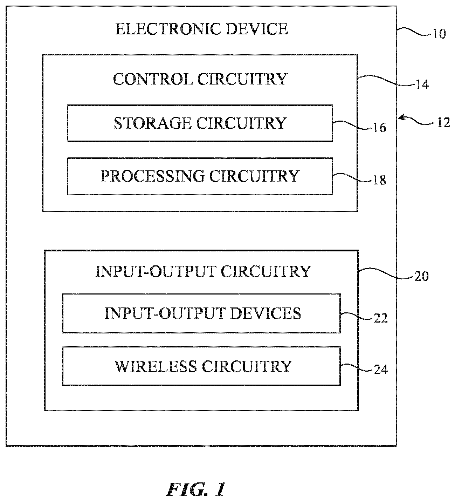

Electronic device 10 of FIG. 1 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the schematic diagram FIG. 1, device 10 may include components located on or within an electronic device housing such as housing 12. Housing 12, which may sometimes be referred to as a case, may be formed of plastic, glass, ceramics, fiber composites, metal (e.g., stainless steel, aluminum, metal alloys, etc.), other suitable materials, or a combination of these materials. In some situations, part or all of housing 12 may be formed from dielectric or other low-conductivity material (e.g., glass, ceramic, plastic, sapphire, etc.). In other situations, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more processors such as microprocessors, microcontrollers, digital signal processors, host processors, baseband processor integrated circuits, application specific integrated circuits, central processing units (CPUs), graphics processing units (GPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 3GPP Fifth Generation (5G) New Radio (NR) protocols, Sixth Generation (6G) protocols, sub-THz protocols, THz protocols, etc.), antenna diversity protocols, satellite navigation system protocols (e.g., global positioning system (GPS) protocols, global navigation satellite system (GLONASS) protocols, etc.), antenna-based spatial ranging protocols, optical communications protocols, or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays, light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support wireless communications. Wireless circuitry 24 (sometimes referred to herein as wireless communications circuitry 24) may include one or more antennas. Wireless circuitry 24 may also include baseband processor circuitry, transceiver circuitry, amplifier circuitry, filter circuitry, switching circuitry, radio-frequency transmission lines, radio-frequency front end circuitry, and/or any other circuitry for transmitting and/or receiving radio-frequency signals using the antenna(s).

Wireless circuitry 24 may transmit and/or receive wireless signals within corresponding frequency bands of the electromagnetic spectrum (sometimes referred to herein as communications bands or simply as "bands"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), other centimeter or millimeter wave frequency bands between 10-100 GHz, sub-THz frequency bands between around 100 GHz and 1000 GHz (e.g., 6G bands), near-field communications (NFC) frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, communications bands under the family of 3GPP wireless communications standards, communications bands under the IEEE 802.XX family of standards, and/or any other desired frequency bands of interest.

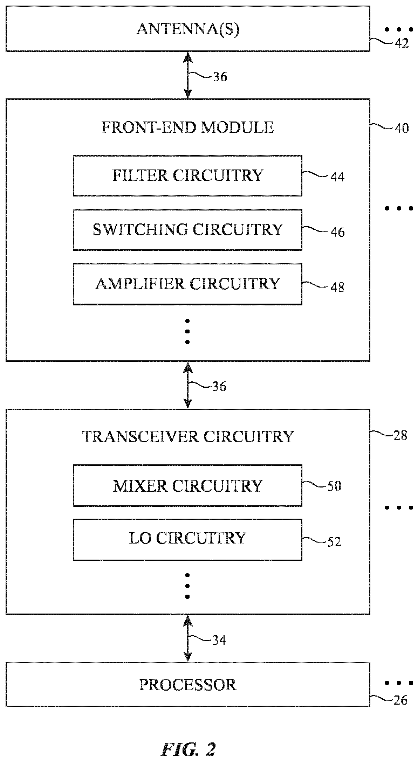

FIG. 2 is a diagram showing illustrative components within wireless circuitry 24. As shown in FIG. 2, wireless circuitry 24 may include one or more processors such as processor(s) 26, radio-frequency (RF) transceiver circuitry such as radio-frequency transceiver 28, radio-frequency front end circuitry such as radio-frequency front end module (FEM) 40, and antenna(s) 42. Processor 26 may be a baseband processor (e.g., may include baseband processing circuitry), an application processor, a digital signal processor, a microcontroller, a microprocessor, a central processing unit (CPU), a programmable device, a combination of these circuits, and/or one or more processors within processing circuitry 18 of FIG. 1. Processor 26 may be configured to generate digital (transmit or baseband) signals. Processor 26 may be coupled to transceiver 28 over path 34 (sometimes referred to as a baseband path). Transceiver 28 may be coupled to antenna 42 via radio-frequency transmission line path 36. If desired, one or more radio-frequency front end modules such as radio-frequency front end module 40 may be disposed along radio-frequency transmission line path 36 between transceiver 28 and antenna 42.

Wireless circuitry 24 may include one or more antennas such as antenna 42. Antenna 42 may be formed using any desired antenna structures. For example, antenna 42 may be an antenna with a resonating element that is formed from loop antenna structures, patch antenna structures, inverted-F antenna (IFA) structures, slot antenna structures, planar inverted-F antenna (PIFA) structures, helical antenna structures, monopole antennas, dipoles, dielectric resonator antenna (DRA) structures, waveguide antenna structures, bowtie antenna structures, hybrids of these designs, etc. If desired, two or more antennas 42 may be arranged into one or more phased antenna arrays (e.g., for conveying radio-frequency signals at millimeter wave frequencies). If desired, parasitic elements may be included in antenna 42 to adjust antenna performance. If desired, antenna 42 may be provided with a conductive cavity that backs the antenna resonating element of antenna 42 (e.g., antenna 42 may be a cavity-backed antenna such as a cavity-backed slot antenna).

In the example of FIG. 2, wireless circuitry 24 is illustrated as including only a single processor 26, a single transceiver 28, a single front end module 40, and a single antenna 42 for the sake of clarity. In general, wireless circuitry 24 may include any desired number of processors 26, any desired number of transceivers 28, any desired number of front end modules 40, and any desired number of antennas 42. Each processor 26 may be coupled to one or more transceiver 28 over respective paths 34. Each transceiver 28 may include a transmitter circuit configured to output uplink signals to antenna 42, may include a receiver circuit configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module disposed thereon.

Front end module (FEM) 40 may include radio-frequency front end circuitry that operates on the radio-frequency signals conveyed (transmitted and/or received) over radio-frequency transmission line path 36. Front end module may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifiers and one or more low-noise amplifiers), impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip.

Filter circuitry 44, switching circuitry 46, amplifier circuitry 48, and other circuitry may be disposed along radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path such that is coupled to the positive antenna feed terminal on antenna 42. Radio-frequency transmission line path 36 may have a ground transmission line signal path that is coupled to the ground antenna feed terminal on antenna 42. This example is illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards. In one suitable implementation, radio-frequency transmission line paths such as radio-frequency transmission line path 36 may also include transmission line conductors integrated within multilayer laminated structures (e.g., layers of a conductive material such as copper and a dielectric material such as a resin that are laminated together without intervening adhesive). The multilayer laminated structures may, if desired, be folded or bent in multiple dimensions (e.g., two or three dimensions) and may maintain a bent or folded shape after bending (e.g., the multilayer laminated structures may be folded into a particular three-dimensional shape to route around other device components and may be rigid enough to hold its shape after folding without being held in place by stiffeners or other structures). All of the multiple layers of the laminated structures may be batch laminated together (e.g., in a single pressing process) without adhesive (e.g., as opposed to performing multiple pressing processes to laminate multiple layers together with adhesive).

Transceiver circuitry 28 may include wireless local area network transceiver circuitry that handles WLAN communications bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network transceiver circuitry that handles the 2.4 GHz Bluetooth^{®} band or other WPAN communications bands, cellular telephone transceiver circuitry that handles cellular telephone bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, 6G bands above 100 GHz, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

The term "convey radio-frequency signals" as used herein means the transmission and/or reception of the radio-frequency signals (e.g., for performing unidirectional and/or bidirectional wireless communications with external wireless communications equipment). In performing wireless transmission, processor 26 may provide digital signals to transceiver 28 over path 34. Transceiver 28 may further include circuitry for converting the baseband signals received from processor 26 into corresponding intermediate frequency or radio-frequency signals. For example, transceiver circuitry 28 may include mixer circuitry 50 that up-converts (or modulates) the baseband signals to intermediate frequencies (e.g., as intermediate frequency (IF) signals), that up-converts the baseband signals to radio frequencies higher than the intermediate frequencies (e.g., as radio-frequency (RF) signals), and/or that up-converts IF signals to radio frequencies prior to transmission over antenna 42. Transceiver circuitry 28 may also include digital-to-analog converter (DAC) and/or analog-to-digital converter (ADC) circuitry that converts signals between digital and analog domains. Transceiver 28 may include a transmitter that transmits the radio-frequency signals over antenna 42 via radio-frequency transmission line path 36 and front end module 40. Antenna 42 may transmit the radio-frequency signals to external wireless equipment by radiating the radio-frequency signals into free space (or into free space through a dielectric cover layer on device 10).

In performing wireless reception, antenna 42 may receive radio-frequency signals from external wireless equipment (e.g., from free space). The received radio-frequency signals may be conveyed to transceiver 28 via radio-frequency transmission line path 36 and front end module 40. Transceiver 28 may include circuitry for converting the received radio-frequency signals into corresponding intermediate frequency or baseband signals. For example, transceiver 28 may use mixer circuitry 50 to downconvert (or demodulate) the received radio-frequency signals to intermediate frequencies, to downconvert the received radio-frequency signals to baseband frequencies (e.g., as baseband signals or baseband data), and/or to downconvert IF signals to baseband frequencies prior to conveying the received signals to processor 26 over path 34. Mixer circuitry 50 can include local oscillator circuitry such as local oscillator (LO) circuitry 52. Local oscillator circuitry 52 can generate oscillator signals that mixer circuitry 50 uses to modulate transmit signals from baseband frequencies to radio frequencies and/or to demodulate received signals from radio frequencies to baseband frequencies.

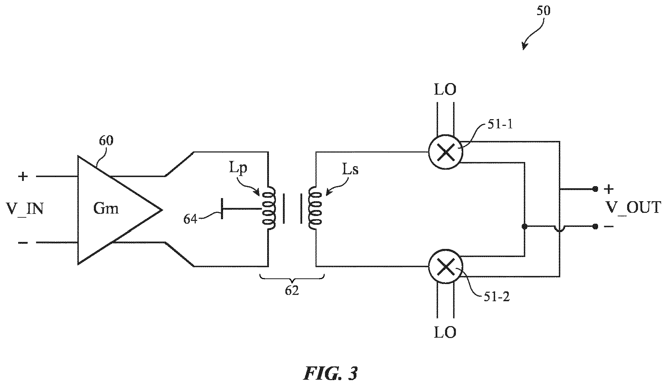

FIG. 3 is a block diagram of illustrative mixer circuitry 50. As shown in FIG. 3, mixer circuitry 50 (sometimes referred to herein simply as mixer 50) may include an input stage such as a transconductance (Gm) circuit 60 (sometimes referred to herein as transconductor 60), a transformer such as transformer 62, and an output stage that includes associated mixer subcircuits 51-1 and 51-2. The pair of mixer subcircuits 51-1 and 51-2 can each include two LO input transistors and is therefore sometimes referred to collectively as a switching quad 51.

Transformer 62 may include a first coil, winding, or inductor such as primary coil Lp. Transformer 62 may also include a second coil, winding, or inductor such as secondary coil Ls. Primary coil Lp may sometimes also be referred to herein as the primary winding Lp or primary inductor Lp of transformer 62. Secondary coil Ls may sometimes also be referred to herein as the secondary winding Ls or secondary inductor Ls of transformer 62. The terminals of primary coil Lp may be coupled to transconductor 60 whereas the terminals of secondary coil Ls are coupled to switching quad 51.

Transconductor 60 may be a differential circuit having a differential input port and a differential output port. The differential input port of transconductor 60 may be coupled to a differential input signal path (e.g., radio-frequency transmission line 36 or path 34 of FIG. 2). Transconductor 60 may receive an input voltage V_{IN} at its differential input port from the differential input signal path. The differential output port of transconductor 60 may be coupled to the terminals of primary winding Lp of transformer 62. Put differently, the differential output port of transconductor 60 may include first and second output terminals and primary winding Lp may be coupled across or between the first and second output terminals.

Input voltage V_{IN} represents the input signal to be upconverted or downconverted by mixer circuitry 50. Mixer circuitry 50 may generate an output signal at its differential output port as output voltage V_{OUT} (e.g., mixer circuitry 50 may upconvert or downconvert an input signal such as input voltage V_{IN} received at the differential input port of transconductor 60 to produce an output signal such as output voltage V_{OUT} at the differential output port of mixer circuitry 50). Mixer circuitry 50 may convert the input signal (e.g., input voltage V_{IN}) from a first frequency to a second frequency different from the first frequency, thereby producing the output signal at the second frequency (e.g., output voltage V_{OUT} may be at the second frequency).

For example, when mixer circuitry 50 is disposed in a transmitter or on a transmit path of transceiver circuitry 28 (FIG. 2), mixer circuitry 50 may upconvert the input signal from a baseband frequency to an intermediate frequency, may upconvert the input signal from an intermediate frequency to a radio frequency, or may upconvert the input signal from a baseband frequency to a radio frequency. As another example, when mixer circuitry 50 is disposed in a receiver or on a receive path of transceiver circuitry 28 (FIG. 2), mixer circuitry 50 may downconvert the input signal from a radio frequency to an intermediate frequency, may downconvert the input signal from a radio frequency to a baseband frequency, or may downconvert the input signal from an intermediate frequency to a baseband frequency.

Transconductor 60 may convert the input voltage V_{IN} received at its differential input port to a corresponding output current at its differential output port. The use of a transconductance circuit (sometimes referred to as a Gm cell) as the input stage of mixer circuitry 50 is exemplary. If desired, other types of amplifier, buffer, driver, or input stage can be employed.

Primary coil Lp of transformer 62 may have a first terminal coupled to a first output terminal of transconductor 60, a second terminal coupled to a second output terminal of transconductor 60, and a corresponding center tap terminal (not shown in FIG. 3 for the sake of clarity). The first and second output terminals of transconductor 60 may collectively form the differential output port of transconductor 60. Secondary coil Ls may have a first terminal coupled to first mixer subcircuit 51-1 of switching quad 51, a second terminal coupled to second mixer subcircuit 51-2 of switching quad 51, and a corresponding center tap terminal (not shown in FIG. 3 for the sake of clarity).

First mixer subcircuit 51-1 of switching quad 51 has a first input coupled to the first terminal of secondary coil Ls, a second input configured to receive an oscillating signal such as local oscillator signal LO from a local oscillator (e.g., local oscillator circuitry 52 of FIG. 2), and an output coupled to the differential output port of mixer circuitry 50. Second mixer subcircuit 51-2 of switching quad 51 has a first input coupled to the second terminal of secondary coil Ls, a second input also configured to receive local oscillator signal LO, and an output coupled to the differential output port of mixer circuitry 50. Switching quad 51 may receive the input signal from transconductor 60 via transformer 62 and may upconvert the input signal to the second frequency (e.g., by modulating local oscillator signal LO with the input signal).

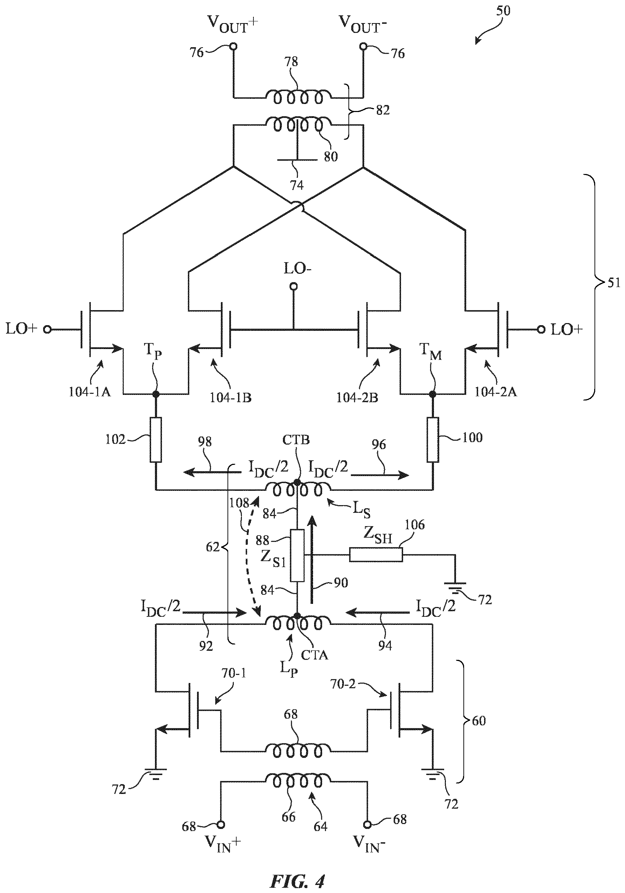

FIG. 4 is a circuit diagram showing one implementation of mixer circuitry 50. Mixer circuitry 50 can represent a transmitting mixer (e.g., a mixer in a transmit path) or a receiving mixer (e.g., a mixer in a receive path).

As shown in FIG. 4, mixer circuitry 50 may include an input transformer such as input transformer 64. Input transformer 64 may have a primary coil 66 and a secondary coil 67. The terminals of primary coil 66 may be coupled to input terminals 68 (e.g., a pair of input terminals 68 that collectively form the differential input port for mixer circuitry 50). The terminals of secondary coil 67 may be coupled to the differential input port of transconductor 60. Mixer circuitry 50 may receive input voltage V_{IN} across input terminals 68. Input voltage V_{IN} is a radio-frequency differential voltage defined by the delta between a first voltage V_{IN}+ at a first input terminal 68 and a second voltage V_{IN}- at a second input terminal 68.

Transconductor 60 may include a set of one or more input transistors 70 such as a first input transistor 70-1 and a second input transistor 70-2. The gate terminals of input transistors 70-1 and 70-2 may collectively form the differential input port of transconductor 60. The gate terminal of input transistor 70-1 may be coupled to the first terminal of the secondary coil 67 in input transformer 64. The gate terminal of input transistor 70-2 may be coupled to the second terminal of secondary coil 67 in input transformer 64. Alternatively, input transformer 64 may be omitted (e.g., input terminals 68 may be directly connected to the gate terminals of input transistors 70-1 and 70-2 such that input terminals 68 form the differential input port of transconductor 60 and such that input voltage V_{IN} is received across the gate terminals of the input transistors).

Input transistors 70-1 and 70-2 can be n-channel devices such as n-type metal-oxide-semiconductor (NMOS) transistors, as one example. Input transistor 70-1 may have a drain terminal coupled to a first terminal of primary coil Lp in transformer 62, a source terminal coupled to a ground line 72 (e.g., a ground power supply line, path, or plane on which a ground voltage or other reference voltage is provided), and a gate terminal configured to receive voltage V_{IN}+ (e.g., via input transformer 64). Input transistor 70-2 may have a drain terminal coupled to a second terminal of the primary coil Lp in transformer 62, a source terminal coupled to ground line 72, and a gate terminal configured to receive voltage V_{IN}-. The terms "source" and "drain" terminals used to refer to current-conveying terminals in a transistor may be used interchangeably and are sometimes referred to as "source-drain" terminals. Thus, the drain terminal of transistor 70-1 can sometimes be referred to as a first source-drain terminal, and the source terminal of transistor 70-1 can be referred to as a second source-drain terminal (or vice versa), etc.

Mixer circuitry 50 may include an output transformer 82. Output transformer 82 may have a primary coil 80 and a secondary coil 78. The terminals of secondary coil 78 may be coupled to respective output terminals 76 of mixer circuitry 50 (e.g., secondary coil 78 may be coupled across or between output terminals 76). The terminals of primary coil 80 may be coupled to the output of switching quad 51. Primary coil 80 may have a center tap contact (e.g., a center tap conductor) coupled to voltage line 74. Voltage line 74 can receive a positive power supply voltage, a ground power supply voltage, a negative power supply voltage, an intermediate voltage between the positive and ground power supply voltages, or other static (direct current or DC) voltage. Implementations in which voltage line 74 provides a positive power supply voltage to the center tap of primary coil 80 are described herein as an example.

Transformer 62 may couple the output of transconductor 60 to the input of switching quad 51. For example, mixer subcircuit 51-1 (FIG. 3) can include a first pair of mixer transistors 104-1A and 104-1B (e.g., a first transistor pair). Mixer transistor 104-1A may have a source terminal coupled to a first terminal of the secondary coil Ls in transformer 62, a gate terminal configured to receive signal LO+, and a drain terminal coupled to a first terminal of the primary coil 80 in output transformer 82. Mixer transistor 104-1B may have a source terminal also coupled to the first terminal of the secondary coil Ls in transformer 62, a gate terminal configured to receive signal LO-, and a drain terminal coupled to a second terminal of the primary coil 80 in output transformer 82. The source terminals of mixer transistors 104-1A and 104-1B may both be coupled to a first tail node Tp of switching quad 51. Tail node Tp may be coupled to the first terminal of the secondary coil Ls in transformer 62.

Mixer subcircuit 51-2 can include a second pair of mixer transistors 104-2A and 104-2B (e.g., a second transistor pair). Mixer transistor 104-2A may have a source terminal coupled to a second terminal of the secondary coil Ls in transformer 62, a gate terminal configured to receive signal LO+, and a drain terminal coupled to the second terminal of the primary coil 80 in output transformer 82. Mixer transistor 104-2B may have a source terminal also coupled to the second terminal of the secondary coil Ls in transformer 62, a gate terminal configured to receive signal LO-, and a drain terminal coupled to the first terminal of the primary coil 80 in output transformer 82. The source terminals of mixer transistors 104-2A and 104-2B may both be coupled to a second tail node Tm of switching quad 51. Tail node Tm may be coupled to the second terminal of the secondary coil Ls in transformer 62 (e.g., secondary coil Ls of transformer 62 may be coupled between tail nodes Tp and Tm). Tail nodes Tm and Tp may form a differential input port of switching quad 51.

Signals LO+ and LO- represent the positive and negative polarities of a differential signal and can collectively be referred to as a local oscillator (LO) signal or an oscillating signal. The gate terminals of mixer transistors 104-1A and 104-1B collectively form a differential input port for receiving the oscillating signal. The gate terminals of mixer transistors 104-2A and 104-2B also collectively form a differential input port for receiving the oscillating signal. The drain terminals of mixer transistors 104-1B and 104-2A and the drain terminals of mixer transistors 104-1A and 104-2B (e.g., the first and second terminals of the primary coil 80 in output transformer 82) collectively form a differential output port of switching quad 51. Output terminals 76 collectively form the differential output port of mixer circuitry 50. Alternatively, transformer 82 may be omitted and the differential output port of switching quad 51 may form the differential output port of mixer circuitry 50 (e.g., the drain terminals of mixer transistors 104-1B and 104-2A may be coupled to a first output terminal 76 whereas the drain terminals of mixer transistors 104-1A and 104-2B may be coupled to a second output terminal 76, where an inductor is coupled between output terminals 76 and has a center tap terminal coupled to voltage line 74).

During operation (e.g., during signal transmission or reception using mixer circuitry 50), input transformer 64 may drive the gate terminals of input transistors 70-1 and 70-2 using the input signal received by mixer 50 (e.g., input voltage V_{IN}). This may cause current corresponding to input voltage V_{IN} to flow across the source-drain terminals of input transistors 70. Transformer 62 may convey the corresponding signal to switching quad 51 via near-field electromagnetic coupling 108 between primary coil Lp and secondary coil Ls (e.g., primary coil Lp is magnetically coupled to secondary coil Ls). The gate terminals of the mixer transistors 104 in switching quad 51 are driven using the LO signal to modulate the LO signal using the signal from transformer 62, which effectively upconverts or downconverts the signal to produce the output signal. Output transformer 82 may pass the output signal onto output terminals 76 (e.g., as output voltage V_{OUT}, which is a differential signal defined by the delta between a first voltage V_{OUT}+ at a first output terminal 76 and a second voltage V_{OUT}- at a second output terminal 76).

Upconversion or downconversion mixers used in high-frequency transceivers such as transceiver circuitry 28 (FIG. 2) have stringent requirements on gain, noise, linearity, emissions, and filtering. Depending on application, a higher mixer gain can help relax the gain and/or linearity requirements of other circuit blocks coupled to the input and/or output of the mixer. Since gain is related to power consumption, Gilbert cell-based mixers (e.g., mixers that output signals at a frequency proportional to the product of two inputs such as input voltage V_{IN} and an LO signal) can perform a trade-off between the two metrics and can impact the overall power efficiency of the transceiver. Coupling transformer 62 between switching quad 51 and transconductor 60 may help to improve mixer gain (e.g., by imparting a voltage/current gain to the signal via near-field electromagnetic coupling 108).

In some implementations, two separate power supply voltages are used to bias switching quad 51 and transconductor 60. In these implementations, the center tap contact of the primary coil Lp in transformer 62 is coupled to a power supply line that receives a first positive power supply voltage and the center tap contact of the secondary coil Ls in transformer 62 is coupled to ground line 72. At the same time, the center tap contact of the primary coil 80 in output transformer 82 receives a second positive power supply voltage that is separate (independent) from the first positive power supply voltage. Switching quad 51 is thereby biased by the second positive power supply voltage provided to the center tap of the primary coil 80 in output transformer 82 and the ground voltage provided to the center tap of the secondary coil Ls in transformer 62, causing a first bias current to flow through switching quad 51. On the other hand, transconductor 60 is biased by the first positive power supply voltage provided to the center tap of the primary coil Lp in transformer 62 and the ground voltage provided to the source terminals of input transistors 70-1 and 70-2, causing a second bias current that is different (independent) from the first bias current to flow through transconductor 60. In other words, the bias current flowing through switching quad 51 is different and decoupled from the bias current flowing through transconductor 60. As the supply current of switching quad 51 can be higher than the bias current through switching quad 51 while mixer transistors 104 are being toggled on an off by the LO signal (sometimes referred to herein as the switching operation of switching quad 51), independently biasing switching quad 51 can cause excessive power consumption in mixer circuitry 50 relative to quiescent conditions.

To minimize power consumption of mixer circuitry 50 without sacrificing linearity or performance, transformer 62 may be a "current reuse" transformer that shares or reuses bias current between primary coil Lp and the secondary coil Ls. For example, as shown in FIG. 4, primary coil Lp may have a center tap contact CTA (sometimes referred to herein as center tap conductor CTA or simply as center tap CTA). Secondary coil Ls may have a center tap contact CTB (sometimes referred to herein as center tap conductor CTB or simply as center tap CTB). Transformer 62 (sometimes referred to herein as current reuse transformer 62) may include a conductive path (line) 84 extending between primary coil Lp and secondary coil Ls. Center tap contact CTA of primary coil Lp may be coupled to a first end of conductive path 84 and center tap contact CTB of secondary coil Ls may be coupled to a second (opposing) end of conductive path 84 (e.g., conductive path 84 may couple, galvanically connect, or short center tap contact CTA of primary coil Lp to center tap contact CTB of secondary coil Ls).

Conductive path 84 may be implemented using a conductive trace, a conductive via, and/or a conductive wire, as examples. In implementations where conductive path 84 is implemented as a conductive trace, the conductive trace may be patterned onto an underlying substrate such as a printed circuit board or a semiconductor substrate. If desired, primary coil Lp and/or secondary coil Ls may be implemented as on-chip inductors formed from windings of conductive traces on one or more layers of the substrate (e.g., the same layer as conductive path 84 and/or additional layers). In implementations where primary coil Lp and secondary coil Ls include conductive traces on different layers of the substrate, conductive path 84 may include a conductive via (e.g., in addition to or instead of a conductive trace used to form conductive path 84) that couples the conductive traces from coils Lp and Ls together (e.g., through one or more layers of the substrate). In implementations where conductive path 84 includes a conductive wire, the conductive wire may be soldered or welded to center tap contacts CTA and/or CTB, if desired.

Conductive path 84 (sometimes referred to herein as center tap path 84 or conductive line 84) may configure transformer 62 to share or reuse bias current between switching quad 51 and transconductor 60. For example, during operation, the positive power supply voltage received by the center tap conductor of the primary coil 80 in output transformer 82 (from voltage line 74) and the ground voltage received by the source terminals of input transistors 70-1 and 70-2 from ground line 72 may produce a bias current I_{DC} (e.g., a DC bias current) that flows through both switching quad 51 and transconductor 60 via, through, or over conductive path 84.

As shown by arrow 92, a first half of bias current I_{DC} flows into the first terminal of the primary coil Lp in transformer 62 from the drain terminal of input transistor 70-1. As shown by arrow 94, a second half of bias current I_{DC} concurrently flows into the second terminal of the primary coil Lp in transformer 62 from the drain terminal of input transistor 70-2. Transformer 62 imparts a passive voltage/current gain to the input signal (e.g., the signal carrying wireless data and corresponding to input voltage V_{IN}) as the transformer passes the input signal from transconductor 60 to switching quad 51 via near-field electromagnetic coupling 108. At the same time, bias current I_{DC} flows from center tap contact CTA of primary coil Lp onto center tap contact CTB of secondary coil Ls over, via, or through conductive path 84 (as shown by arrow 90). From center tap contact CTB of secondary coil Ls, a first half of bias current I_{DC} flows onto tail node Tp of switching quad 51 (as shown by arrow 98). A second half of bias current I_{DC} concurrently flows onto tail node Tm of switching quad 51 from center tap contact CTB (as shown by arrow 96). Bias I_{DC} current may thereby bias the operation of switching quad 51.

In this way, switching contact 51 does not require a separate/dedicated power supply and instead is powered using the bias current I_{DC} received from transconductor 60 over conductive path 84 in transformer 62. In other words, conductive path 84 in transformer 62 configures transformer 62 to share the same bias current I_{DC} between transconductor 60 and switching quad 51, which may serve to minimize power consumption by mixer circuitry 50 while concurrently leveraging the passive voltage/current gain from transformer 62, thereby allowing mixer circuitry 50 to meet gain, linearity, noise, and/or filtering requirements of other circuitry coupled to the input and/or output of the mixer circuitry. Assuming a quality factor of Q = 12 for transformer coils and Q = 8 for capacitors, bias current sharing by transformer 62 may reduce power consumption in mixer circuitry 50 by 8 mW or greater, may produce 4 dB or greater gain improvement, may produce comparable linearity, may reduce LO swing by as much as 50% (thereby further saving LO power), and/or may reduce the physical size of switching quad 51 by as much as 60% relative to implementations where switching quad 51 and transconductor 60 are biased by separate bias currents (e.g., different positive power supply voltages) and where transformer 62 does not include conductive path 84, for example.

In some implementations, conductive path 84 includes a single conductive line that directly connects center tap contacts CTA and CTB (e.g., with no other components disposed on conductive path 84). If desired, a node on conductive line 84 may be coupled to ground line 72 (e.g., by an additional conductive path). If desired, a common mode impedance termination may be disposed on conductive path 84. The common mode impedance termination may include a first common mode impedance termination 88 (e.g., having impedance Zsi) disposed on conductive path 84 and coupled in series between center tap contacts CTA and CTB and/or may include a second common mode impedance termination 106 (e.g., having impedance Z_{SH}) disposed on the conductive path between conductive path 84 and ground line 72 (e.g., second common mode impedance termination 106 may form a shunt impedance from conductive path 84). Common mode impedance terminations 88 and 106 may perform impedance termination and/or filtering of the common mode signal conveyed over conductive path 84 (e.g., where two differential lines driven with a common mode stimulus exhibit an even mode corresponding to each line being driven with the same amplitude and polarity and exhibit an odd mode corresponding to each line being driven with the same amplitude but opposite polarities).

Additionally or alternatively, a differential mode impedance termination may be coupled between the terminals of secondary coil Ls and tail nodes Tp and Tm. For example, as shown in FIG. 4, a first differential mode impedance termination 102 may be coupled in series between the first terminal of secondary coil Ls and tail node Tp and/or a second differential mode impedance termination 100 may be coupled in series between the second terminal of secondary coil Ls and tail node Tm. Differential mode impedance terminations 102 and 100 may perform impedance termination and/or filtering of the differential mode signal conveyed over conductive path 84.

Impedance terminations 100, 102, 88, and 106 may each include any desired number of resistive, inductive, and/or capacitive components arranged in any desired manner. If desired, one or more of impedance terminations 100, 102, 88, and 106 may include switching circuitry. The switching circuitry may be adjusted to actively adjust the impedance of one or more of the impedance terminations. If desired, the switching circuitry may have at least one switch state in which the impedance termination is bypassed (e.g., impedance terminations 100, 102, 88, and/or 106 may be switched into or out of use as needed). Mixer circuitry 50 may include all of impedance terminations 100, 102, 88, and 106, only differential mode impedance terminations 100 and/or 102, only common mode impedance terminations 88 and/or 106, or impedance terminations 100, 102, 88, and 106 may be omitted. Impedance terminations 100, 102, 88, and 106 may help to further increase linearity, reduce emission, and/or improve filtering by mixer circuitry 50, for example.

As used herein, the term "concurrent" means at least partially overlapping in time. In other words, first and second events are referred to herein as being "concurrent" with each other if at least some of the first event occurs at the same time as at least some of the second event (e.g., if at least some of the first event occurs during, while, or when at least some of the second event occurs). First and second events can be concurrent if the first and second events are simultaneous (e.g., if the entire duration of the first event overlaps the entire duration of the second event in time) but can also be concurrent if the first and second events are non-simultaneous (e.g., if the first event starts before or after the start of the second event, if the first event ends before or after the end of the second event, or if the first and second events are partially non-overlapping in time). As used herein, the term "while" is synonymous with "concurrent."

Device 10 may gather and/or use personally identifiable information. It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

The methods and operations described above in connection with FIGS. 1-4 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry 18 of FIG. 1, etc.). The processing circuitry may include microprocessors, central processing units (CPUs), application-specific integrated circuits with processing circuitry, or other processing circuitry.

In accordance with an embodiment, mixer circuitry is provided that includes a transformer having a first winding and a second winding, a first input transistor coupled to a first terminal of the first winding and configured to receive an input signal, a second input transistor coupled to a second terminal of the first winding and configured to receive the input signal, a first pair of mixer transistors coupled to a first terminal of the second winding and configured to receive an oscillating signal, a second pair of mixer transistors coupled to a second terminal of the second winding and configured to receive the oscillating signal, and a conductive path that couples a center tap contact of the first winding to a center tap contact of the second winding.

In accordance with another embodiment, the mixer circuitry includes an output transformer having a third winding and a fourth winding, the first pair of mixer transistors being coupled between the output transformer and the first terminal of the second winding, and the second pair of mixer transistors being coupled between the output transformer and the second terminal of the second winding, and a positive power supply line coupled to a center tap contact of the third winding.

In accordance with another embodiment, the first input transistor has a first source-drain terminal coupled to the first terminal of the first winding, a second source-drain terminal coupled to a ground line, and a first gate terminal configured to receive the input signal.

In accordance with another embodiment, the second input transistor has a third source-drain terminal coupled to the second terminal of the first winding, a fourth source-drain terminal coupled to the ground line, and a second gate terminal configured to receive the input signal.

In accordance with another embodiment, the positive power supply line and the ground line are configured to produce a DC bias current that flows across the conductive path between the center tap contact of the first winding and the center tap contact of the second winding.

In accordance with another embodiment, the mixer circuitry includes a first impedance termination disposed on the conductive path.

In accordance with another embodiment, the mixer circuitry includes a second impedance termination that couples the conductive path to a ground line.

In accordance with another embodiment, the first pair of mixer transistors have first source-drain terminals coupled to the first terminal of the second winding, the first pair of mixer transistors have first gate terminals configured to receive the oscillating signal, the second pair of mixer transistors have second source-drain terminals coupled to the second terminal of the second winding, and the second pair of mixer transistors have second gate terminals configured to receive the oscillating signal.

In accordance with another embodiment, the mixer circuitry includes a first impedance termination coupled between the first source-drain terminals and the first terminal of the second winding, and a second impedance termination coupled between the second source-drain terminals and the second terminal of the second winding.

In accordance with another embodiment, the mixer circuitry includes a third impedance termination disposed on the conductive path.

In accordance with another embodiment, the first impedance termination includes a first differential mode impedance termination, the second impedance termination includes a second differential mode impedance termination, and the third impedance termination includes a common mode impedance termination.

In accordance with another embodiment, the mixer circuitry includes an additional conductive path that couples a node on the conductive path to a ground line.

In accordance with another embodiment, the first pair of mixer transistors and the second pair of mixer transistors are configured to generate an output signal based on the oscillating signal and the input signal, the output signal having a different frequency than the input signal, and the conductive path being configured to share a DC bias current between the first pair of mixer transistors, the second pair of mixer transistors, the first input transistor, and the second input transistor.

In accordance with an embodiment, mixer circuitry is provided that includes a transconductor, mixer transistors, and a transformer that couples an output of the transconductor to an input of the mixer transistors, the transformer includes a first coil having a first center tap contact, and a second coil magnetically coupled to the first coil, the second coil having a second center tap contact that is coupled to the first center tap contact over a conductive path.

In accordance with another embodiment, the mixer transistors have first source-drain terminals coupled to first and second terminals of the second coil and have gate terminals configured to receive an oscillating signal.

In accordance with another embodiment, the transconductor includes transistors with second source-drain terminals coupled to first and second terminals of the first coil.

In accordance with another embodiment, the transistors in the transconductor have third source-drain terminals coupled to a ground line.

In accordance with another embodiment, the mixer transistors have fourth source-drain terminals, the mixer circuitry includes a third coil, the fourth source-drain terminals are coupled to first and second terminals of the third coil, the third coil having a third center tap contact coupled to a power supply line.

In accordance with an embodiment, an electronic device is provided that includes an antenna, and a transceiver configured to convey radio-frequency signals using the antenna, the transceiver including a first pair of transistors having first gate terminals configured to receive an input signal and having first source-drain terminals, a second pair of transistors having second gate terminals configured to receive a local oscillator (LO) signal and having second source-drain terminals, a third pair of transistors having third gate terminals configured to receive the LO signal and having third source-drain terminals, and a transformer having a first inductor and a second inductor, the first inductor is coupled between the first source-drain terminals, the second inductor is coupled between the second source-drain terminals and the third source-drain terminals, and a center tap of the first inductor is coupled to a center tap of the second inductor over a conductive path.

In accordance with another embodiment, the first pair of transistors having fourth source-drain terminals, the second pair of transistors having fifth source-drain terminals, the third pair of transistors having sixth source-drain terminals, the second pair of transistors being configured to generate an output signal at the fifth source-drain terminals based on the input signal, the third pair of transistors being configured to generate the output signal at the sixth source-drain terminals based on the input signal, the output signal being at a different frequency than the input signal, and the electronic device includes a ground power supply line coupled to the fourth source-drain terminals, a third inductor coupled between the fifth source-drain terminals and the sixth source-drain terminals, and a positive power supply line coupled to a center tap of the third inductor.

The foregoing is illustrative and various modifications can be made to the described embodiments. The foregoing embodiments may be implemented individually or in any combination.

## Claims

1. Mixer circuitry comprising:
a transformer having a first winding and a second winding;
a first input transistor coupled to a first terminal of the first winding and configured to receive an input signal;
a second input transistor coupled to a second terminal of the first winding and configured to receive the input signal;
a first pair of mixer transistors coupled to a first terminal of the second winding and configured to receive an oscillating signal;
a second pair of mixer transistors coupled to a second terminal of the second winding and configured to receive the oscillating signal; and
a conductive path that couples a center tap contact of the first winding to a center tap contact of the second winding.

2. The mixer circuitry of claim 1, further comprising:
an output transformer having a third winding and a fourth winding, the first pair of mixer transistors being coupled between the output transformer and the first terminal of the second winding, and the second pair of mixer transistors being coupled between the output transformer and the second terminal of the second winding; and
a positive power supply line coupled to a center tap contact of the third winding.

3. The mixer circuitry of claim 2, wherein the first input transistor has a first source-drain terminal coupled to the first terminal of the first winding, a second source-drain terminal coupled to a ground line, and a first gate terminal configured to receive the input signal.

4. The mixer circuitry of claim 3, wherein the second input transistor has a third source-drain terminal coupled to the second terminal of the first winding, a fourth source-drain terminal coupled to the ground line, and a second gate terminal configured to receive the input signal.

5. The mixer circuitry of claim 3, wherein the positive power supply line and the ground line are configured to produce a DC bias current that flows across the conductive path between the center tap contact of the first winding and the center tap contact of the second winding.

6. The mixer circuitry of claim 1, further comprising:
a first impedance termination disposed on the conductive path.

7. The mixer circuitry of claim 6, further comprising:
a second impedance termination that couples the conductive path to a ground line.

8. The mixer circuitry of claim 1, wherein the first pair of mixer transistors have first source-drain terminals coupled to the first terminal of the second winding, the first pair of mixer transistors have first gate terminals configured to receive the oscillating signal, the second pair of mixer transistors have second source-drain terminals coupled to the second terminal of the second winding, and the second pair of mixer transistors have second gate terminals configured to receive the oscillating signal.

9. The mixer circuitry of claim 8, further comprising:
a first impedance termination coupled between the first source-drain terminals and the first terminal of the second winding; and
a second impedance termination coupled between the second source-drain terminals and the second terminal of the second winding.

10. The mixer circuitry of claim 9, further comprising:
a third impedance termination disposed on the conductive path.

11. The mixer circuitry of claim 10, wherein the first impedance termination comprises a first differential mode impedance termination, the second impedance termination comprises a second differential mode impedance termination, and the third impedance termination comprises a common mode impedance termination.

12. The mixer circuitry of claim 1, further comprising:
an additional conductive path that couples a node on the conductive path to a ground line.

13. The mixer circuitry of claim 1, wherein the first pair of mixer transistors and the second pair of mixer transistors are configured to generate an output signal based on the oscillating signal and the input signal, the output signal having a different frequency than the input signal, and the conductive path being configured to share a DC bias current between the first pair of mixer transistors, the second pair of mixer transistors, the first input transistor, and the second input transistor.
